# EUROPEAN PATENT APPLICATION

(11) **EP 4 190 562 A1**
(43) Date of publication of application: **07.06.2023**
(21) Application number: 22208451.9
(22) Date of filing: 20.11.2022
(51) Int. Cl.: B41F 15/08, B41F 15/26, B41M 1/12, H05K 3/12, H05K 3/00

(54) **STAGGERED PRINTING OF SINGULATED WORKPIECES**

(30) Priority: 06.12.2021 GB 202117575
(71) Applicant: ASMPT SMT Singapore Pte. Ltd, Singapore 768924 (SG)
(72) Inventor: HANSFORD, Keith Michael, Weymouth, DT4 9TH (GB); WONG, Hing Wah, 768775 Singapore (SG)
(74) Representative: Emerson, Peter James

(57) **Abstract**

A method for printing a print medium onto an array of workpieces supported within a carrier includes printing a first workpiece of the array using a first workpiece support assembly (13) at a first printing area (11), moving (T) the carrier to a second printing area (12) which overlies a second workpiece support assembly (14), lifting the second workpiece support assembly (14) to engage with a second workpiece of the array, but not the first workpiece, and lift it from the carrier, and printing the print medium onto the second workpiece. Additionally, a corresponding printing machine and a production line are provided.

## Description

This invention relates to a method for printing a print medium onto an array of workpieces supported within a carrier, a printing machine for printing a print medium onto an array of workpieces supported within a carrier and a production line for printing a print medium onto an array of workpieces supported within a carrier.

### Background and Prior Art

Industrial screen-printing machines typically apply a conductive print medium, such as solder paste, silver paste or conductive ink, onto a planar workpiece, such as a circuit board, by applying the conductive print medium through a pattern of apertures in a printing screen (sometimes referred to as a mask, foil or stencil) using an angled blade or squeegee. The same machines may also be used to print certain non-conductive media, such as glue or other adhesive, onto workpieces.

To ensure high quality printing, it is necessary to support the workpiece so that the surface to be printed is parallel to the printing screen, generally horizontal, with the workpiece support being capable of withstanding the pressure placed upon it during the printing operation, especially by the downward pressure applied by the squeegee, while maintaining the correct alignment of the workpiece.

Where the area of the pattern is relatively small with respect to the area of the screen, it is possible to include more than one pattern within the screen, thus allowing more than one area of a board, or more than one board, to be printed simultaneously using the same screen. Alternatively, more than one relatively small screen may be used within the same printing machine to enable the more than one area of a board, or more than one board, to be printed simultaneously using respective screens.

A workpiece support assembly, capable of supporting and individually aligning a multiplicity of relatively small workpieces (commonly referred to as "singulated" workpieces) has been described in EP3693168A1. FIG. 1 schematically shows an example of such an assembly 1, here including a 2 × 4 array of individual support "towers" 2. Each tower 2 is topped with a support surface 3 upon which a workpiece (not shown) may be supported during a printing operation. Furthermore, each tower 2 is individually actuable to move in orthogonal directions X and Y, which would typically be in the horizontal plane, and also to rotate about an orthogonal Z axis, which would typically extend in the vertical direction to provide so-called theta correction. As described in EP3693168A1, such movement may be advantageously provided through the use of a parallel kinematic actuation system within each tower. Other arrays of greater or smaller dimension are of course possible.

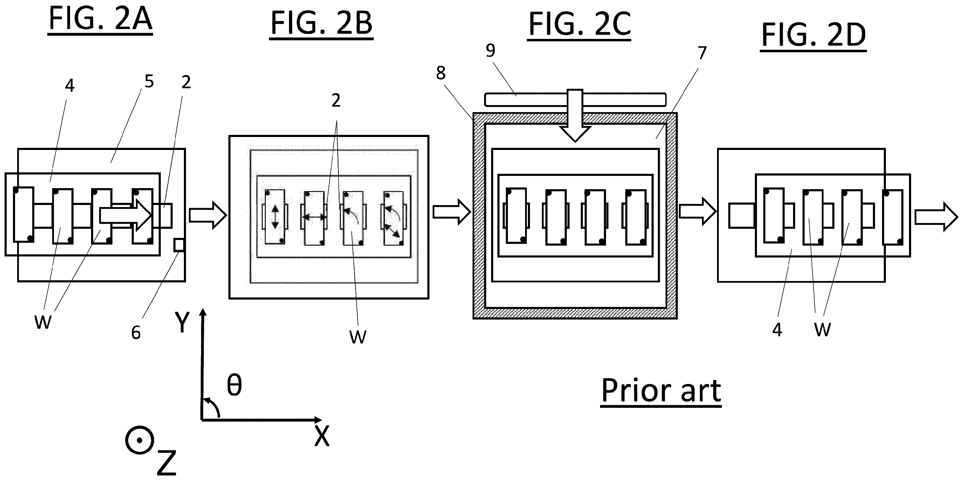

Typically, when printing singulated workpieces, a plurality of the workpieces will be located in a carrier, and the workpieces will be moved through the printing machine, and indeed between different machines along an assembly line, within the carrier. FIGs. 2A-D schematically show, from above, the following basic steps which may be performed using a workpiece support assembly as described in EP3693168A1. In FIGs. 2A-D, for simplicity a workpiece support assembly having a 1x4 tower array is shown.
i) As shown in FIG. 2A, a carrier 4, retaining a multiplicity of workpieces W therein, is transported into a printing machine (not shown) in the horizontal X-direction using a conveyor (not shown), and aligned within the printing machine by abutting it against a physical stop element 6, so that the workpieces W are located directly above respective towers 2 of the workpiece support assembly on a rising table 5;
ii) the towers 2 and respective overlying workpieces W are brought into contact, for example by lifting rising table 5 which carries the workpiece support assembly, so that the workpieces W are lifted from the carrier 4;
iii) as shown in FIG. 2B, each workpiece W is aligned as necessary by suitable actuation of the respective underlying towers 2 in the X, Y and theta directions;
iv) the workpieces W are brought into contact with a patterned printing screen 7 (shown transparently for clarity in FIG. 2C), through further lifting of the rising table 5, the printing screen 7 being tensioned within a frame 8;
v) as shown in FIG. 2C, a print stroke is performed, using a squeegee 8 to deposit print medium onto the workpieces W through the apertures of the printing screen 7;
vi) the workpieces W are brought out of contact with the printing screen 7 and returned to the carrier 4, by lowering the rising table 5; and
vii) as shown in FIG. 2D, the physical stop element 6 is moved out of engagement with the carrier 4, and the carrier 4, with its workpieces W, is transported out of the printing machine along the horizontal X direction.

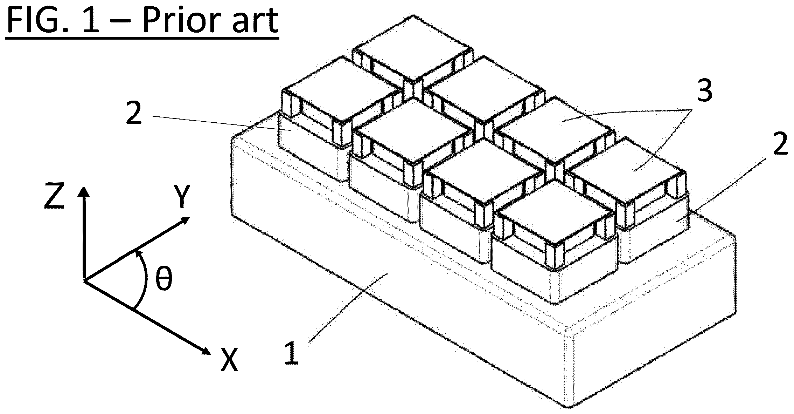

Those skilled in the art will recognise that in order to function as intended, the individual towers of an array such as that shown in FIG. 1 must have a certain minimum spacing therebetween (i.e. the "pitch" of the array), so that each tower may move and / or rotate freely, without risk of collision with an adjacent tower in the array.

When using a carrier loaded with singulated substrates, such a system generally works well, however some users of printing machines may wish to print singulated workpieces located in a carrier in which the pitch of adjacent workpieces in the carrier is smaller than the corresponding pitch of the array.

A methodology for printing singulated workpieces located in a carrier in which the pitch of adjacent workpieces on the carrier in the X-direction (as shown in FIG. 2) is smaller than the corresponding pitch of the array is described in GB2009474.4, and in this methodology alternate workpieces within a carrier may be printed by a printing machine in a first print operation, the carrier advanced in the X direction within the printing machine, and the unprinted alternate workpieces printed in a second print operation. However, the methodology set out in that document cannot be used to print singulated workpieces located in a carrier in which the pitch of adjacent workpieces on the carrier in the γ-direction (horizontal and orthogonal to the X direction, as shown in FIG. 2), is smaller than the corresponding pitch of the array.

The present invention seeks to overcome this problem, and provide a suitable methodology for printing singulated workpieces located in a carrier in which the pitch of adjacent workpieces on the carrier in the γ-direction, being orthogonal to the direction of travel of the carrier along a production line, iis smaller than the corresponding pitch of the array of a workpiece support assembly. Advantageously, the methodology as described in GB2009474.4 may also be performed, so that singulated workpieces in a carrier with small separation in both X and Y directions may be printed using a workpiece support assembly.

In accordance with the present invention, this aim is achieved by using a two-stage printing process with offset tooling.

### Summary of the Invention

In accordance with a first aspect of the present invention there is provided a method for printing a print medium onto an array of workpieces supported within a carrier which in use travels along a production line parallel to a horizontal X axis, said array comprising at least a first workpiece and at least a second workpiece which are offset along a line parallel to a horizontal Y axis orthogonal to the X axis, the method comprising the steps of:
i) moving the carrier along the production line parallel to the X axis to a first printing area overlying a first workpiece support assembly;
ii) lifting the first workpiece support: assembly to engage with the first workpiece, but not the second workpiece, and lift the first workpiece from the carrier;
iii) printing the print medium onto the first workpiece;
iv) lowering the first workpiece support assembly to return the first workpiece to the carrier;
v) moving the carrier along the production line to a second printing area which is spaced from the first printing area along the production line parallel to the X axis, the second printing area overlying a second workpiece support assembly;
vi) lifting the second workpiece support assembly to engage with the second workpiece, but not the first workpiece, and lift it from the carrier; and
vii) printing the print medium onto the second workpiece.

In accordance with a second aspect of the present invention there is provided a printing machine for printing a print medium onto an array of workpieces supported within a carrier, comprising:
a carrier transport operative to move the carrier through the printing machine in a direction parallel to a horizontal X axis;
a first printing area and a second printing area which are offset along the carrier transport parallel to the X axis;
a first workpiece support assembly located beneath the first printing area and a second workpiece support assembly located beneath the second printing area, the first workpiece support assembly being vertically movable into and out of engagement with a first workpiece of the array and the second workpiece support assembly being vertically movable into and out of engagement with a second workpiece of the array when the carrier is located in the respective first or second printing area;
at least one squeegee for applying print medium to the first workpiece at the first printing area and for applying print medium to the second workpiece at the second printing area;
wherein the first workpiece support assembly and the second workpiece support assembly each comprise a support surface adapted to engage with a respective workpiece of the array; and
wherein the support surface of the first workpiece support assembly is offset from the support surface of the second workpiece support assembly along a horizontal Y axis orthogonal to the X axis.

In accordance with a third aspect of the present invention there is provided a production line for printing a print medium onto an array of workpieces supported within a carrier, comprising:
a first printing machine comprising:
   a first printing area;
   a first workpiece support assembly located beneath the first printing area, the first workpiece support assembly being vertically movable into and out of engagement with a first workpiece of the array when the carrier is located in the first printing area; and
   a first squeegee for applying print medium to the first workpiece;
a second printing machine comprising:
   a second printing area;
   a second workpiece support assembly located beneath the second printing area, the second workpiece support assembly being vertically movable into and out of engagement with a second workpiece of the array when the carrier is located in the second printing area; and
   a second squeegee for applying print medium to the second workpiece; and
a carrier transport operative to move the carrier through the first and second printing machines in a direction parallel to a horizontal X axis, the first and second printing machines being offset along the carrier transport parallel to the X axis;
wherein the first workpiece support assembly and the second workpiece support assembly each comprise a plurality of discrete and horizontally spaced support surfaces, each support surface adapted to engage with a respective workpiece of the array; and
wherein each support surface of the first workpiece support assembly is offset from the each support surface of the second workpiece support assembly along a horizontal Y axis orthogonal to the X axis.

Other specific aspects and features of the present invention are set out in the accompanying claims.

### Brief Description of the Drawings

The invention will now be described with reference to the accompanying drawings (not to scale), in which:
FIG. 1 schematically shows a known multiple tower support system;
FIGs. 2A-D schematically show a printing operation for a known tower support system;
FIG. 3 schematically shows, from above, an exemplary printing machine suitable for performing the method of the present invention for a 1x2 array of workpieces;
FIG. 4 schematically shows, from above, a printing arrangement suitable for performing the method of the present invention for a 3x4 array of workpieces; and
FIGs. 5 to 10 schematically show, from above, steps in a method of printing a large array of singulated workpieces.

### Detailed Description of the Preferred Embodiments of the Invention

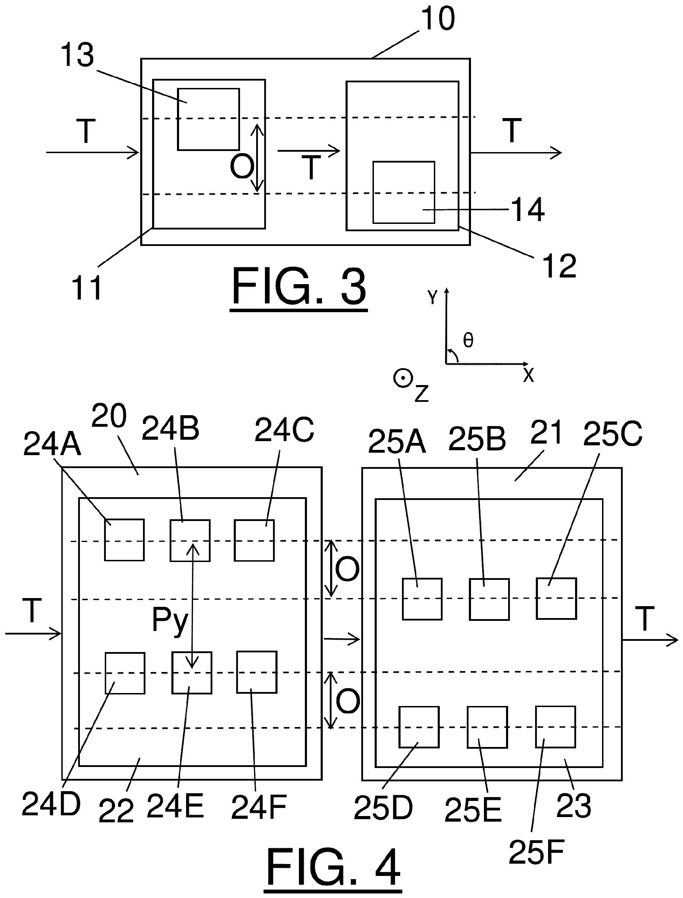

FIG. 3 schematically shows, from above, an exemplary printing machine 10 suitable for performing the method of the present invention for a 1x2 array of workpieces, i.e. an array with two singulated workpieces (not shown) which are spaced in a direction parallel to the Y axis shown. The printing machine 10 is adapted to provide both a first printing area 11 and a second printing area 12 within its interior. Preferably, each of the first and second printing areas 11, 12 are associated with a respective squeegee (not shown) held by a respective print carriage (not shown), the squeegees being operative to spread print medium over a respective stencil or screen (not shown, hereafter for simplicity simply referred to as a "stencil") located above each respective printing area 11, 12. Alternatively, both the first and second printing areas 11, 12 may be located under respective aperture patterns provided within a common stencil (not shown) which is associated either with a common, relatively large squeegee (not shown) operative to spread print medium over both aperture patterns simultaneously, or separate squeegees (not shown) operative to spread print medium over respective aperture patterns. Respective tooling is provided underneath each of the first and second printing areas 11, 12, including a first workpiece support assembly with a first workpiece support surface 13 and a second workpiece support assembly with a second workpiece support surface 14. Each of the first and second workpiece support surfaces 13, 14 is adapted to engage with and support a single respective workpiece. The tooling is advantageously located on a respective rising table (not shown), so that each of the first and second workpiece support surfaces 13, 14 may be raised into engagement with a respective singulated workpiece, positioned in a carrier, above the respective workpiece support surface. By continuing to raise the lifting table, the singulated workpieces are lifted away from the carrier and into contact with the underside of the overlying stencil, in which position a print operation may be effected using the squeegee or squeegees to spread print medium onto the workpieces through apertures in the stencil. Advantageously, each of the first and second workpiece support surfaces 13, 14 is an upper surface of a workpiece support assembly tower similar to those shown in FIGs. 1 or 2, which include actuation mechanisms such that the respective workpiece support surface is independently drivable to move within the horizontal plane, allowing the singulated workpieces supported thereon to be aligned in the X, Y and theta directions shown, before they are fully lifted into engagement with the underside of the stencil. As shown in FIG. 3, the first workpiece support surface 13 is offset from the second workpiece support surface 14 along the horizontal Y axis orthogonal to the X axis, with this offset being shown as "O", and the offset O being chosen to be equal to the pitch of the two workpieces in the array. Where the workpiece support assembly comprises independently drivable towers as set out above, the position of the first and second workpiece support surfaces 13, 14 and the ensuing offset O are set using the "home" positions of the towers, i.e. where the respective workpiece support surfaces are at the centre of their ranges of horizontal movement.

The printing machine 10 also comprises a carrier transport such as conveyors (not shown), which, as is well-known in the art per se, are operative to transport a carrier (not shown) in a transport direction T parallel to the X axis shown, through the printing machine 10. In more detail, the carrier transport is operative to transport a carrier with unprinted workpieces to the first printing area 11 for printing of a first workpiece, then transport the carrier with the one printed and an unprinted workpiece to the second printing area 12 for printing of the second workpiece, and subsequently transport the carrier with fully printed workpieces away from the printing machine 10 and to other modules of a production line as required, such as inspection machines (not shown) and / or placement machines (not shown).

It can be seen that the printing machine 10, adapted to perform two separate print operations on different respective workpieces of the array, can be used to print such a 1×2 array of workpieces even where the pitch of the workpieces is small, in particular where the pitch is too small to enable the use of a single workpiece support assembly having two workpiece support surfaces. While the overall time taken to print both workpieces of a single carrier using such a two-stage process is longer - to a first approximation twice as long as a single print operation - since the two print operations can be performed simultaneously on two successive carriers, a series of carriers can be printed with only a very minor increase in total time taken. For example, a partially printed carrier (i.e. a carrier in one of its workpieces is printed) can have its second workpiece printed at the second printing area 12 while a subsequent carrier can have its first workpiece printed at the first printing area 11, and then both these carriers are moved along transport direction T at the same time, the fully printed carrier (i.e. the carrier which has both its workpieces printed) to a separate module of the production line external to the printing machine 10, and the partically printed carrier to the second printing area 12, while at the same time a subsequent unprinted carrier (i.e. a carrier whose workpieces are unprinted) is transported to the first printing area 11.

The form of tooling used may be chosen depending on the specific application. For example, in alternative embodiments, where it, is required to print a larger array of singulated workpieces held by a carrier, each of the first workpiece support assembly and the second workpiece support assembly may comprise a plurality of discrete and horizontally spaced support surfaces. Methods for printing such arrays will be described in more detail with reference to FIG. 4 below.

FIG. 4 schematically shows, from above, a printing arrangement suitable for performing the method of the present invention for a 3x4 array of workpieces, i.e. an array with a matrix of twelve singulated workpieces (not shown) such that in each row of the array (aligned parallel to the X axis shown) there are three mutually spaced workpieces, and in each column of the array (aligned parallel to the Y axis shown) there are four mutually spaced workpieces.

As with the embodiment described with respect to FIG. 3 above, again first and second printing areas 22, 23 are provided, however in this embodiment each of these printing areas is located within a respective printing machine, i.e. the first printing area 22 is located within a first printing machine 20 and the second printing area 23 is located within a second printing machine 21, with these located within a common production line. The first and second printing machines 20, 21 include cooperating means such as conveyors (not shown), forming part of the carrier transport, operative to move carriers (not shown) in a transport direction T parallel to the X axis shown, from a location upstream of the first printing machine 20, to the first printing area 22, away from the first printing machine 20 and into the second printing machine 21, to the second printing area 23, and then away from the second printing machine 21 and optionally to other modules (not shown) of the production line such as an inspection machine and placement machines. As with the previous embodiment, each of the first and second printing areas 22, 23 are associated with a respective squeegee (not shown) held by a respective print carriage (not shown), the squeegees being operative to spread print medium over a respective stencil (not shown) located above each respective printing area 22, 23. Respective tooling is provided underneath each of the first and second printing areas 22, 23, including a first workpiece support assembly with a first workpiece support surface 24A and other support surfaces of the first workpiece support assembly 24B-F, and a second workpiece support assembly with a second workpiece support surface 25A and other support surfaces of the second workpiece support assembly 25B-F. Each of the workpiece support surfaces 24A-F, 25A-F is adapted to engage with and support a single respective workpiece. The tooling is advantageously located on a respective rising table (not shown), so that each of the workpiece support surfaces 24A-F, 25A-F may be raised into engagement with a respective singulated workpiece, positioned in a carrier, above the respective workpiece support surface. By continuing to raise the lifting table, the singulated workpieces are lifted away from the carrier and into contact with the underside of the overlying stencil, in which position print operations may be effected using the squeegees to spread print medium onto the workpieces through apertures in the stencils. Advantageously, each workpiece support surfaces 24A-F, 25A-F is an upper surface of a workpiece support assembly tower similar to those shown in FIGs. 1 or 2, which include actuation mechanisms such that the respective workpiece support surface is independently drivable to move within the horizontal plane, allowing the singulated workpieces supported thereon to be aligned in the X, Y and theta directions shown, before they are fully lifted into engagement with the underside of the stencil.

As shown in FIG. 4, the first workpiece support surface 24A, as well as the other support surfaces in the same row, i.e. 24B and 24C, is offset from the second workpiece support surface 25A (as well as the other support surfaces in the same row, i.e. 25B and 25C) along the horizontal Y axis orthogonal to the X axis, with this offset being shown as "O", and the offset O being chosen to be equal to the pitch of adjacent rows of workpieces in the array. Similarly, the row of workpiece support surfaces 24D-F is offset from the row of workpiece support surfaces 25D-F by the same amount. Where the workpiece support assembly comprises independently drivable towers as set out above, the position of the first and second workpiece support surfaces 24A, 25A and the ensuing offset O are set using the "home" positions of the towers, i.e. where the respective workpiece support surfaces are at the centre of their ranges of horizontal movement. FIG. 4 shows clearly that the pitch Py of adjacent support surfaces of the first and second workpiece support assemblies in a direction parallel to the Y axis is greater than the pitch of adjacent workpieces of the array in a direction parallel to the Y axis (which as noted above is equal to the offset O). Therefore this arrangement, adapted to perform two separate print operations on different respective workpieces of the array, can be used to print such a 3x4 array of workpieces even where the pitch of the workpieces is small, in particular where the pitch is too small to enable the use of a single workpiece support assembly having two workpiece support surfaces.

The use of two separate printing machines 20, 21 in the embodiment shown in FIG. 4 is advantageous since standard printing machines can be used to perform the method, subject of course to correct fitting of offset tooling and appropriate programming. In contrast, use of a single printing machine such as printing machine 10 of FIG. 3 requires a large and specialist printing machine. Nevertheless, it is equally possible to use a single printing machine such as 10 to print relatively large arrays of workpieces.

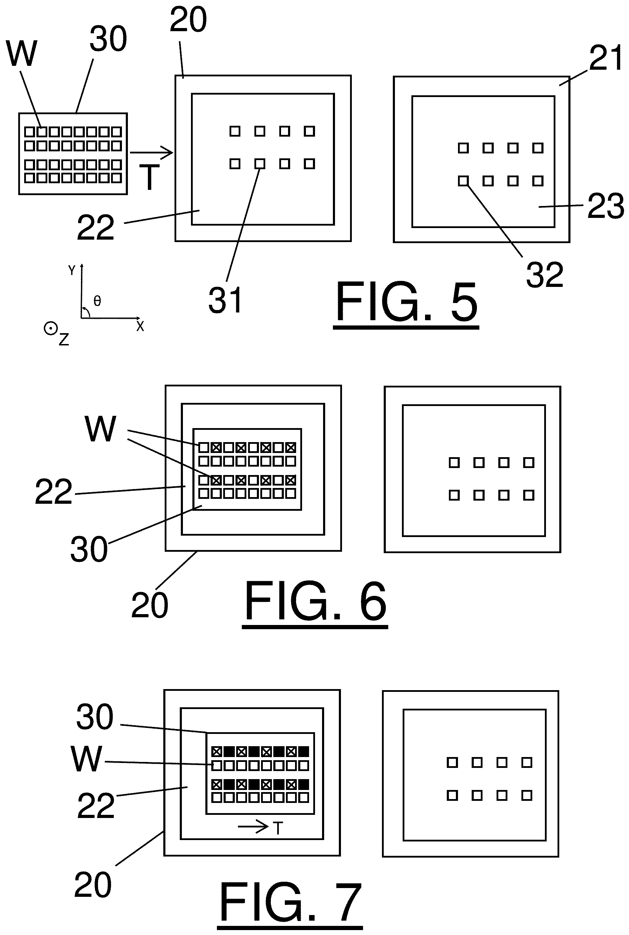

FIGs. 5 to 10 schematically show, from above, steps in a method of printing a large array of singulated workpieces. In this example, the pitch of the workpieces W in both the X and Y directions is small, such that there is insufficient space for all workpieces W in either a single row or a single column of the array to be printed simultaneously on a common workpiece support assembly. To perform printing of all the workpieces, the methodology of the present invention as described for example with reference to FIG. 4 above is combined with a methodology such as is described in GB2009474.4 outlined previously.

In FIG. 5, a carrier 30 holding thirty-two unprinted singulated workpieces W is shown upstream of a first printing machine 20 and a second printing machine 21. The workpieces W are arranged in a 8x4 array, i.e. having four rows and eight columns. As shown, the rows of the array are not regularly spaced, but the top two rows as shown are slightly separated from the lower two rows as shown - this does not affect the methodology or implementation of the present invention. The carrier 30 is supported on a carrier transport such as a conveyor (not shown), ready to be transported in a transport direction T, parallel to the horizontal X axis shown, to the first printing machine 20. The first printing machine 20 includes a first printing area 22 corresponding to the dimensions of a patterned stencil (not shown) provided within the first printing machine 20. Similarly, the second printing machine 21 includes a second printing area 23 corresponding to the dimensions of a patterned stencil (not shown) provided within the second printing machine 21. Each of the first and second printing machines 20, 21 includes a squeegee (not shown) operative to spread print medium (not shown) onto the upper surface of the respective stencil and through the aperture patterns (not shown) provided therein. Furthermore, each of the first and second printing machines 20, 21 includes tooling mounted on a vertically-moveable rising table (not shown), the tooling comprising a workpiece support assembly of the type generally described above with reference to FIGs. 1 and 2, having a plurality of towers topped with respective discrete and horizontally-spaced workpiece support surfaces 31 (in first printing machine 20) and 32 (in second printing machine 21) which are independently drivable to move within the horizontal X-Y plane. Eight workpiece support surfaces 31, 32 are provided in each of the first and second printing machines 20, 21, and FIG. 5 shows that each support surface 31 of the first workpiece support assembly is offset from the each support surface 32 of the second workpiece support assembly along the horizontal Y axis orthogonal to the X axis. Furthermore, the pitch of adjacent workpiece support surfaces 31, 32 is set to be double the pitch of the workpieces W along parallel to the X axis, so that workpiece support surfaces 31, 32 are the same distance apart parallel to the X axis as alternate workpieces W. Parallel to the Y axis, the pitch of the workpieces W is not constant, but the spacing of the workpiece support surfaces 31, 32 is still such that they are the same distance apart parallel to the Y axis as alternate workpieces W. The position of the first and second printing machine workpiece support surfaces 31, 32 and the ensuing offset are set using the "home" positions of the towers, i.e. where the respective workpiece support surfaces are at the centre of their ranges of horizontal movement.

In FIG. 6, the carrier 30 has been transported into the first printing area 22 of the first printing machine 20, such that each second workpiece W of the first and third rows of the array directly overlies a respective workpiece support surface 31. The rising table has been driven upwards so that the workpiece support surfaces 31, in their "home" positions, engage and lift up the corresponding workpieces W, which workpieces are marked with an "x" in FIG. 6. The workpiece support surfaces 31 are driven in the X-Y place as required to correct the orientation of the supported workpieces W, and then the lifting table is raised further until the workpieces contact the underside of the overlying stencil. These workpieces are then printed by using the squeegee to spread print medium across the upper surface of the stencil and through the apertures therein.

Following this printing step, the rising table is lowered, returning the printed workpieces to the carrier. The workpiece support surfaces 31 are returned to their home positions. The carrier transport then advances the carrier 30 along the transport direction T by a distance equal to the workpiece pitch parallel to the X direction. The rising table is then raised so that the workpiece support surfaces 31 engage with and lift up the overlying workpieces W. This arrangement is shown in FIG. 7, where the workpieces which are solid black are those which have already been printed, while again workpieces marked with an "x" have been so lifted. The workpiece support surfaces 31 are driven in the X-Y place as required to correct the orientation of the supported workpieces W, and then the lifting table is raised further until the workpieces contact the underside of the overlying stencil. These workpieces are then printed by using the squeegee to spread print medium across the upper surface of the stencil and through the apertures therein. Following this printing step, the rising table is lowered, returning the printed workpieces to the carrier. The workpiece support surfaces 31 are returned to their home positions. At this point, all the workpieces W in the first and third rows are printed.

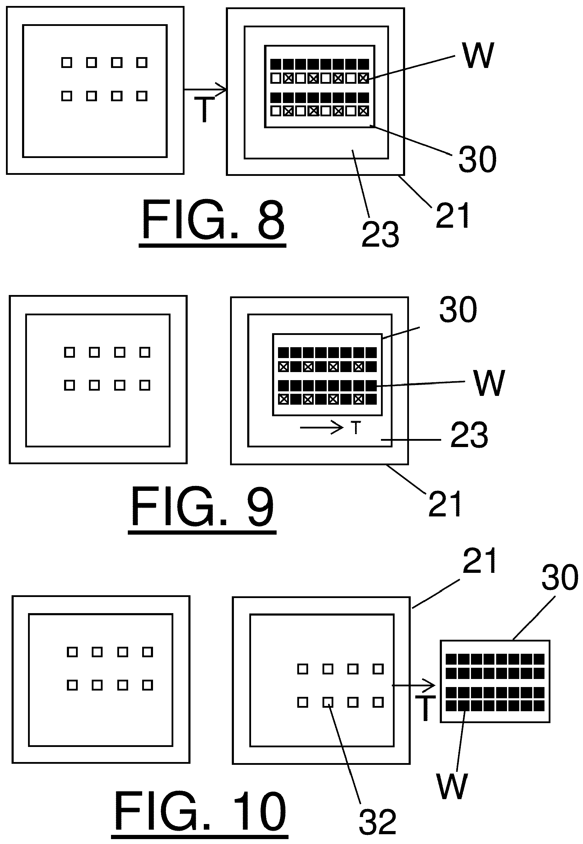

The carrier transport then transfers the carrier 30 to the second printing area 23, within the second printing machine 21, such that each second workpiece W of the second and fourth rows of the array directly overlies a respective workpiece support surface 32. It should be noted that, although not shown in these figures, a new carrier may be transferred to the first printing area 22 at this point. The rising table of the second printing machine 21 is then raised so that the workpiece support surfaces 32 engage with and lift up the overlying workpieces W. This arrangement is shown in FIG. 8, where again the workpieces which are solid black are those which have already been printed, while workpieces marked with an "x" have been so lifted. The workpiece support surfaces 32 are driven in the X-Y place as required to correct the orientation of the supported workpieces W, and then the lifting table is raised further until the workpieces contact the underside of the overlying stencil. These workpieces are then printed by using the squeegee to spread print medium across the upper surface of the stencil and through the apertures therein.

Following this printing step, the rising table is lowered, returning the printed workpieces to the carrier. The workpiece support surfaces 32 are returned to their home positions. The carrier transport then advances the carrier 30 along the transport direction T by a distance equal to the workpiece pitch parallel to the X direction. The rising table is then raised so that the workpiece support surfaces 32 engage with and lift up the overlying workpieces W. This arrangement is shown in FIG. 9, where again the workpieces which are solid black are those which have already been printed, while workpieces marked with an "x" have been so lifted. The workpiece support surfaces 32 are driven in the X-Y place as required to correct the orientation of the supported workpieces W, and then the lifting table is raised further until the workpieces contact the underside of the overlying stencil. These workpieces are then printed by using the squeegee to spread print medium across the upper surface of the stencil and through the apertures therein.

Following this printing step, the rising table is lowered, returning the printed workpieces to the carrier. The workpiece support surfaces 32 are returned to their home positions. Then, as shown in FIG. 10, the carrier 30 with all workpieces W having been printed is advanced in transport direction T out of the second printing machine 21 and to downstream production line modules as required. Any carrier present in the first printing area 22 may be transferred to the second printing area 23 at this point.

The above-described embodiments are exemplary only, and other possibilities and alternatives within the scope of the invention will be apparent to those skilled in the art.

### Reference numerals used:

1 - Workpiece support assembly
2 - Tower
3 - Support surface
4 - Carrier
5 - Rising table
6 - Physical stop element
7 - Printing screen
8 - Frame
9 - Squeegee
10 - Printing machine
11 - First printing area
12 - Second printing area
13 - First workpiece support surface
14 - Second workpiece support surface
20 - First printing machine
21 - Second printing machine
22 - First printing area
23 - Second printing area
24A - First workpiece support surface
24B-F - Support surfaces of a first workpiece support assembly
25A - Second workpiece support surface
25B-F - Support surfaces of a second workpiece support assembly
30 - Carrier
31 - First printing machine workpiece support surfaces
32 - Second printing machine workpiece support surfaces
Py - Pitch in Y direction
O - Offset
T - Transport direction
W - Workpieces

## Claims

1. A method for printing a print medium onto an array of workpieces supported within a carrier which in use travels along a production line parallel to a horizontal X axis, said array comprising at least a first workpiece and at least a second workpiece which are offset along a line parallel to a horizontal Y axis orthogonal to the X axis, the method comprising the steps of:
i) moving the carrier along the production line parallel to the X axis to a first printing area overlying a first workpiece support assembly;
ii) lifting the first workpiece support assembly to engage with the first workpiece, but not the second workpiece, and lift the first workpiece from the carrier;
iii) printing the print medium onto the first workpiece;
iv) lowering the first workpiece support assembly to return the first workpiece to the carrier;
v) moving the carrier along the production line to a second printing area which is spaced from the first printing area along the production line parallel to the X axis, the second printing area overlying a second workpiece support assembly;
vi) lifting the second workpiece support assembly to engage with the second workpiece, but not the first workpiece, and lift it from the carrier; and
vii) printing the print medium onto the second workpiece.

2. The method of claim 1, further comprising the steps of:
viii) lowering the second workpiece support assembly to return the second workpiece to the carrier; and
ix) moving the carrier along the production line, away from the second printing area.

3. The method of either of claims 1 and 2, wherein the first and second printing areas are located in separate respective printing machines.

4. The method of either of claims 1 and 2, wherein the first and second printing areas are located within a common printing machine.

5. The method of any preceding claim, wherein said array comprises a first subset of workpieces including the first workpiece, and a second subset of workpieces including the second workpiece, and wherein
step ii) comprises lifting the first workpiece support assembly to engage with the first subset of workpieces, but not the second subset of workpieces, and lift the first subset of workpieces from the carrier;
step iii) comprises printing the print medium onto the first subset of workpieces; step iv) comprises lowering the first workpiece support assembly to return the first subset of workpieces to the carrier;
step vi) comprises lifting the second workpiece support assembly to engage with the second subset of workpieces, but not the first subset of workpieces, and lift it from the carrier; and
step vii) comprises printing the print medium onto the second subset of workpieces.

6. The method of any preceding claim, wherein the first workpiece support assembly and the second workpiece support assembly each comprise a plurality of discrete and horizontally spaced support surfaces, each support surface adapted to engage with a respective workpiece of the array.

7. The method of claim 6, wherein each support surface is independently drivable to move within the horizontal plane, step iii) comprises positioning the first workpiece within the horizontal plane by driving its respective support surface, before printing the first workpiece, and step vii) comprises positioning the second workpiece within the horizontal plane by driving its respective support surface, before printing the second workpiece.

8. The method of either of claims 6 and 7, wherein each support surface of the first workpiece support assembly is offset from the each support surface of the second workpiece support assembly along the Y axis.

9. The method of any of claims 6 to 8, wherein the pitch of adjacent support surfaces of the first and second workpiece support assemblies in a direction parallel to the Y axis is greater than the pitch of adjacent workpieces of the array in a direction parallel to the Y axis.

10. The method of any preceding claim, comprising the initial steps of:
providing a first printing area and a second printing area which are offset along the production line parallel to the X axis; and
providing a first workpiece support assembly located beneath the first printing area and a second workpiece support assembly located beneath the second printing area, the first workpiece support assembly being vertically movable into and out of engagement with the first workpiece and the second workpiece support assembly being vertically movable into and out of engagement with the second workpiece when the carrier is located in the respective first or second printing area.

11. A printing machine for printing a print medium onto an array of workpieces supported within a carrier, comprising:
a carrier transport operative to move the carrier through the printing machine in a direction parallel to a horizontal X axis;
a first printing area and a second printing area which are offset along the carrier transport parallel to the X axis;
a first workpiece support assembly located beneath the first printing area and a second workpiece support assembly located beneath the second printing area, the first workpiece support assembly being vertically movable into and out of engagement with a first workpiece of the array and the second workpiece support assembly being vertically movable into and out of engagement with a second workpiece of the array when the carrier is located in the respective first or second printing area;
at least one squeegee for applying print medium to the first workpiece at the first printing area and for applying print medium to the second workpiece at the second printing area;
wherein the first workpiece support assembly and the second workpiece support assembly each comprise a support surface adapted to engage with a respective workpiece of the array; and
wherein the support surface of the first workpiece support assembly is offset from the support surface of the second workpiece support assembly along a horizontal Y axis orthogonal to the X axis.

12. The printing machine of claim 11, wherein the support surface is independently drivable to move within the horizontal plane.

13. The printing machine of either of claims 11 and 12, wherein each of the first workpiece support assembly and the second workpiece support assembly comprises a plurality of discrete and horizontally spaced support surfaces.

14. A production line for printing a print medium onto an array of workpieces supported within a carrier, comprising:
a first printing machine comprising:
a first printing area;
a first workpiece support assembly located beneath the first printing area, the first workpiece support assembly being vertically movable into and out of engagement with a first workpiece of the array when the carrier is located in the first printing area; and
a first squeegee for applying print medium to the first workpiece;
a second printing machine comprising:
a second printing area;
a second workpiece support assembly located beneath the second printing area, the second workpiece support assembly being vertically movable into and out of engagement with a second workpiece of the array when the carrier is located in the second printing area; and
a second squeegee for applying print medium to the second workpiece; and
a carrier transport operative to move the carrier through the first and second printing machines in a direction parallel to a horizontal X axis, the first and second printing machines being offset along the carrier transport parallel to the X axis;
wherein the first workpiece support assembly and the second workpiece support assembly each comprise a plurality of discrete and horizontally spaced support surfaces, each support surface adapted to engage with a respective workpiece of the array; and
wherein each support surface of the first workpiece support assembly is offset from the each support surface of the second workpiece support assembly along a horizontal Y axis orthogonal to the X axis.

15. The production line of claim 14, wherein each support surface is independently drivable to move within the horizontal plane.
